(19) Europäisches Patentamt
European Patent Office
Office européen des brevets

(11) EP 1 879 234 A2

(12) **EUROPEAN PATENT APPLICATION**

(43) Date of publication:
**16.01.2008 Bulletin 2008/03**

(51) Int Cl.:
***H01L 29/49*** *(2006.01)*

(21) Application number: **07112365.7**

(22) Date of filing: **12.07.2007**

(84) Designated Contracting States:
**AT BE BG CH CY CZ DE DK EE ES FI FR GB GR HU IE IS IT LI LT LU LV MC MT NL PL PT RO SE SI SK TR**
Designated Extension States:
**AL BA HR MK YU**

(30) Priority: **14.07.2006 US 831161 P**
**05.07.2007 US 773570**

(71) Applicant: **Air Products and Chemicals, Inc.**
**Allentown, PA 18195-1501 (US)**

(72) Inventors:
- **Markley, Thomas John**
**Blandon, PA 19510 (US)**
- **Braymer, Thomas Albert**
**Allentown, PA 18103 (US)**
- **Kretz, Christine Peck**
**Macungie, PA 18062 (US)**
- **Weigel, Scott Jeffrey**
**Allentown, PA 18104 (US)**

(74) Representative: **Schwabe, Hans-Georg**
**Schwabe, Sandmair, Marx**
**Patentanwälte**
**Stuntzstrasse 16**
**D-81677 München (DE)**

(54) **Low temperature sol-gel silicates as dielectrics or planarization layers for thin film transistors**

(57) Traditionally, sol-gel silicates have been reported as being high temperature processable at 400C to give reasonably dense films that showed good leakage current densities (<5 x $10^{-8}$ A/$cm^2$). Recently we have discovered that we are able to prepare films from particular combinations of sol-gel silicate precursors that cure at 135°C to 250°C and give good leakage current density values (9 x $10^{-9}$ A/$cm^2$ to 1 x $10^{-10}$ A/$cm^2$) as well, despite the decrease in processing temperatures. These are some of the first examples of silicates being cured at lower temperatures where the leakage current density is sufficient low to be used as low temperature processed or solution processable or printable gate dielectrics for flexible or lightweight thin film transistors. These formulations may also be used in the planarization of stainless steel foils for thin film transistors and other electronic devices.

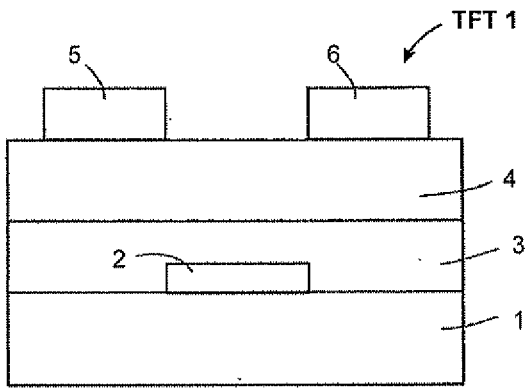


Figure 1

EP 1 879 234 A2

## Description

This Application claims the benefit of U.S. Provisional Application No. 60/831,161, filed on July 14, 2006. The disclosure of this Provisional Application is hereby incorporated by reference.

CROSS-REFERENCE TO RELATED APPLICATIONS

The subject matter of the instant invention is related to U.S. Patent Application Publication No. 2006/0097360A1, and U.S. Patent Application No. 11/752,722; both hereby incorporated by reference.

BACKGROUND OF THE INVENTION

This invention relates to the use of low temperature processed sol-gel silica-containing formulations to provide silicate films at relatively low temperatures. In one aspect, films prepared from low temperature processing of these formulations can be used as gate dielectrics or interlayer dielectrics for thin film transistors (TFTs). In another aspect, higher temperature variants of these formulations may be used as planarization layers, for example, on stainless steel foils or substrates (e.g., TFTs on steel foils).

The electronics industry is seeking rapidly processable gate dielectric, interlayer dielectric, and planarizing film for use in fabricating thin film transistors at low and high temperatures, particularly, though not exclusively, for printed transistors. However, the need for materials compatibility, processability, and good electrical properties over a wide range of conditions and deposition techniques and at temperatures equal to or lower than 400°C has presented a significant problem. This problem has been a very difficult one to solve, particularly for inorganic compositions (e.g, film forming compositions) where the desired temperature for reaction (i.e. cure) is below 180°C for gate dielectric or interlayer dielectric materials for TFTs on plastic and is at or below 250°C-300°C for gate dielectric or interlayer dielectric materials for TFTs on glass. A similar problem exists for planarizing films for substrates for TFTs or other electronic devices on plastic, other organic, or stainless steel. Thick uniform films are often needed (>1μ) along with solvent resistance, processing temperatures at or below 180°C for planarizing films for plastic, near or above 250°C for planarizing films for steel, and at or above 400°C for planarizing films for stainless steel for other types of TFTs. Processing temperatures for silicates used as a planarizing films on organic substrates may occur below 400°C but typically occurs below 250°C, or more typically occurs below 180°C.

Therefore, there is a need in the electronic industry for the replacement of the traditionally high temperature processed (400°C) silica, silicate, or silicon nitride-based interlayer dielectric materials with materials of lower processing temperatures that may be deposited via typical solution casting techniques such as spin-coating, slot extrusion, spraying, or printing. Silicates and their modified versions are typically processed at 400-450°C and are typically deposited via chemical vapor deposition or spin coating techniques. However, for many TFT applications, the required processing temperatures are much lower than 400°C. While polymeric materials may be used as replacements for silica as gate dielectric or interlayer dielectric materials and may be deposited at temperatures lower than 400°C, they typically provide decreases in TFT mobility and TFT performance degradation due to their propensity to absorb water and they are typically processed in nitrogen ($N_2$) or vacuum. Many of the polymers that have been tested as interlayer or gate dielectric or planarization materials for thin film transistors or other electronic devices lack the ability to withstand contact with other solvents that may be used in depositing subsequent layers because they are not sufficiently crosslinked. Thus, a dielectric material that meets the criteria above combined with the crosslinking needed to give good solvent resistance is also desirable.

Display and imaging thin film transistors and transistor arrays (also known as backplanes) require suitable dielectric films. Interlayer and gate dielectric films are typically required to have low leakage current densities, high breakdown voltages, and cure temperatures of 130 to 180°C or 250°C to 300°C. After these films are cured, it is desirable that they have solvent resistance, low moisture absorption, and compatibility with other layers in the TFT.

Planarizing films for substrates such as stainless steel may be processed at or above 180°C, but may also be processed at or above 250°C or between 400°C and 600°C when used for low temperature polysilicon (LTPS) transistors. While some silicates have been reported for this application, most lack the ability to be deposited in one step at thicknesses greater than 1 μ while providing a sufficient degree of planarization such that the stainless steel mimics glass. It is most desirable if the planarizing film is self-planarizing meaning that it needs no additional mechanical processing (such as chemical mechanical planarization or CMP) in order to be sufficiently smooth to put a transistor array on top of it. Planarization layers are required for both organic and inorganic (eg. metal) substrates.

BRIEF SUMMARY OF THE INVENTION

This invention solves problems associated with conventional materials by providing a sol-gel silicate formulation that can be processed at a relatively low temperature. The inventive silicate may be applied onto a wide range of substrates and used, for example, as a gate or interlayer dielectric in thin film transistors (TFTs) or as a planarizing film

for a range of substrates. The inventive silicate may also be used in methods for applying the formulation as a film in TFTs to be used for a variety of applications such as the planarization of stainless steel and other substrates, among other end-uses.

One aspect of the invention, relates to a composition comprising the sol-gel precursors, at least one solvent, at least one acid, and optionally, at least one base, at least one surfactant, at least one porogen, at least one flow and levelling agent, or mixtures thereof that may be used as a gate or interlayer dielectric or a planarizing film. This film that may be effectively processed or cured at temperatures at or above about 400°C, at or below about 400°C, at or below about 250°C, at or below about 180°C, depending upon the application. For example, such a composition can be employed to provide a dielectric or planarizing film for thin film transistors or other electronic devices or applications.

Another aspect of the invention relates to a method for providing a substrate with a sol-gel silicate gate or interlayer dielectric film (that is processed at a temperature from about 130°C to about 300°C in air), having a dielectric constant below 3.5, an acceptable leakage current density, and low moisture absorption, wherein the method comprises : applying the sol-gel formulation of the invention to the substrate via either spin coating, slot extrusion, doctor blading, spraying, printing, or other solution deposition methods, and heating the resulting film to a temperature at or below about 300°C, or, typically, below about 250°C, or, more typically, below 180°C, typically with all heating done in air.

Still further provided is a thin film transistor device that contains a film of low temperature cross-linked sol-gel formulation as the gate dielectric, interlayer dielectric, and/or planarizing film, particularly where the planarizing film is self-planarizing.

Further provided is an electronic device that contains the low temperature processed sol-gel silicate formulation of the invention as a gate or/and interlayer dielectric or/and as a planarizing film.

## BRIEF DESCRIPTION OF THE DRAWINGS

The invention will be described in conjunction with the following drawings which are not intended to limit the invention but to serve as representative examples wherein:

Fig. 1 is a drawing of a one embodiment of a thin film transistor containing the film of the invention.

Fig. 2 is a drawing of a second embodiment of a thin film transistor containing the film of the invention.

Fig. 3 is a drawing of a third embodiment of a thin film transistor containing the film of the invention.

Fig. 4 is a drawing of a fourth embodiment of a thin film transistor containing the film of the invention.

## DETAILED DESCRIPTION OF THE INVENTION

Broadly, the instant invention relates to a sol-gel silicate formulation that can be processed at a relatively low temperature for a gate dielectric application, particularly at or below about 250°C, or more particularly, at or below about 180°C. This same or a similar sol-gel silicate formulation may be processed at higher temperatures such as at or above about 250°C or at or above about 400°C and used as a planarizing film. The inventive silicate may be applied onto a wide range of substrates and used, for example, as a gate or interlayer dielectric or planarizing film in thin film transistors (TFTs) or other electronic devices. The composition can also form a film or layer having a desirable leakage current density (e.g., a leakage current density of less than about $5 \times 10^{-8}$ A/cm$^2$). When employed in electronic devices such as thin film transistors, the silicate can comprise a dielectric material prepared from sol-gel silica-containing formulations that may be cured at or below about 300°C. In one aspect of the invention, there is provided a composition for preparing a gate dielectric or interlayer dielectric from sol-gel silica-containing formulations that are cured at or below about 300°C, or, typically less than about 250°C, or, usually less than about 180°C. This composition comprises at least one silica source capable of being sol-gel processed and at least one solvent, water, at least one acid, and optionally, at least one base, at least one surfactant, at least one porogen, at least one flow and levelling agent, or mixtures thereof. This composition may optionally have a molar ratio of carbon to silicon within the silica source of at least about 0.5.

In another aspect of the invention, there is provided a similar or identical composition for preparing a planarizing film from sol-gel silica-containing formulations that are cured at or above about 250°C, or at or above about 400°C. This composition comprises at least one silica source capable of being sol-gel processed and at least one solvent, water, at least one acid, and, optionally, at least one base, at least one surfactant, at least one porogen, at least one flow and leveling agent, or mixtures thereof. This composition may optionally have a molar ratio of carbon to silicon within the silica source of at least about 0.5.

In a further aspect of the invention, there is provided a method of planarizing a substrate using the composition comprising at least one silica source capable of being sol-gel processed and at least one solvent, water, at least one acid, and, optionally, at least one base, at least one surfactant, at least one porogen, at least one flow and leveling agent, or mixtures thereof. This method includes a film that is self planarizing. A self planarizing film will cover a variety of features or irregularitites in a substrate to provide a surface with a relatively low rms roughness value of the coated substrate without having to add other layers, a second coating of the film, or do little or no further mechanical processing

to the film.

A common measure that is used to gauge smoothness is the rms roughness value obtained over 25μm × 25μm section of a substrate. Route-mean-square (Rq) is the standard deviation of the Z values (or rms roughness) in the image. It is calculated according to the formula:

$$RMS = \sqrt{\frac{\sum_{i=1}^{N}(Z_i - Z_{ave})^2}{N}}$$

where $Z_{avg}$ is the average Z value within the image; $Z_i$ is the current value of Z; and N is the number of points in the image. This value is not corrected for tilt in the plane of the image; therefore, planefitting or flattening the data will change this value.

Typically, one measures the rms roughness of a planarizing film on a substrate before and after deposition of the film on the substrate. A common rms roughness value of stainless steel substrates that are used for flexible display substrates before depositing a film is 200nm rms roughness and a good planarizing film is one that achieves an rms roughness value over this range of <20nm.

In another aspect of the invention, there is provided a substrate to be used for a variety of electronic devices that contains the planarizing film of the invention. Although a particular example of such a device is a thin film transistor array, the invention is not limited to this type of device. Other examples of such devices include but are not limited to thin film transistors, photovoltaics, solar cells, display devices, flat panel displays, flexible displays, memory devices, basic logic devices, integrated circuits, RFID tags, sensors, smart objects, or X-ray imaging devices.

Materials suitable as the silica source include silica sources capable of being sol-gel processed and comprising a compound selected from the group consisting of compounds represented by at least one of the following formulas:

i) $R_aSi(OR^1)_{4-a}$, wherein R independently represents a hydrogen atom, a fluorine atom, or a monovalent organic group; $R^1$ represents a monovalent organic group; and a is an integer 1 or 2; $Si(OR^2)_4$, where $R^2$ represents a monovalent organic group; and

ii) $R^3_b(R^4O)_{3-b}Si-R^7-Si(OR^5)_{3-c}R^6_c$, wherein $R^4$ and $R^5$ may be the same or different and each represents a monovalent organic group; $R^3$ and $R^6$ may be the same or different; b and c may be the same or different and each is a number ranging from 0 to 3; $R^7$ represents an oxygen atom, a phenylene group, a biphenyl, a napthylene group, or a group represented by $-(CH_2)_n-$, wherein n is an integer ranging from 1 to 6. These compounds can be combined by any suitable method with at least one of
at least one solvent;
water;
at least one acid;
and, optionally, at least one base, at least one surfactant, at least one porogen, at least one flow and levelling agent, or mixtures thereof.

As previously described, the composition can comprise at least one silica source. The silica sources are capable of being sol-gel processed such as, for example, by hydrolytic polycondensation or similar means. Monomeric or precondensed, hydrolyzable and condensable compounds having an inorganic central atom such as silicon are hydrolyzed and precondensed by adding water, and optionally a catalyst, until a sol forms and then condensation to a gel is conducted usually by adding a pH-active catalyst or other means. The gel can then be converted into a continuous network by treatment with one or more energy sources such as thermal, radiation, and/or electron beam. The composition may comprise from about 5% to about 95% by weight, or from about 5% to about 75% by weight, or from about % to about 65% by weight of at least one silica source. A "silica source", as used herein, comprises a compound comprising at least one of silicon (Si), oxygen (O), carbon (C), and optionally additional substituents such as, at least one of H, B, P, or halide atoms, organic groups such as alkyl groups, or aryl groups

The following are non-limiting examples of silica sources suitable for use in the composition described herein. In the chemical formulas which follow and in all chemical formulas throughout this document, the term "independently" should be understood to denote that the subject R group is not only independently selected relative to other R groups bearing different superscripts, but is also independently selected relative to any additional species of the same R group. For example, in the formula $RaSi(OR^1)_{4-a}$, when "a" is 2, the two R groups need not be identical to each other or to $R^1$. In addition, in the following formulas, the term "monovalent organic group" relates to an organic group bonded to an

element of interest, such as Si or O, through a single C bond, i.e., Si-C or O-C. Examples of monovalent organic groups comprise an alkyl group, an aryl group, an unsaturated alkyl group, and/or an unsaturated alkyl group substituted with alkoxy, ester, acid, carbonyl, or alkly carbonyl functionality. The alkyl group may be a linear, branched, or cyclic alkyl group having from 1 to 6 carbon atoms such as, for example, a methyl, ethyl, propyl, butyl, pentyl, or hexyl group. Examples of aryl groups suitable as the monovalent organic group can comprise phenyl, methylphenyl, ethylphenyl and fluorophenyl. In certain embodiments, one or more hydrogens within the alkyl group may be substituted with an additional atom such as a halide atom (i.e., fluorine), or an oxygen atom to give a carbonyl or ether functionality.

In certain embodiments, the silica source may be represented by the following formula: $R_aSi(OR^1)_{4-a}$, wherein R independently represents a hydrogen atom, a fluorine atom, or a monovalent organic group; $R^1$ independently represents a monovalent organic group; and a is an integer ranging from 1 to 2. Specific examples of the compounds represented by $R_aSi(OR^1)_{4-a}$ can comprise at least one member selected from the group of methyltrimethoxysilane, methyltriethoxysilane, methyltri-n-propoxysilane, methyltri-iso-propoxysilane, methyltri-n-butoxysilane, methyltri-sec-butoxysilane, methyltri-tert-butoxysilane, methyltriphenoxysilane, ethyltrimethoxysilane, ethyltriethoxysilane, ethyltri-n-propoxysilane, ethyltri-iso-propoxysilane, ethyltri-n-butoxysilane, ethyltri-sec-butoxysilane, ethyltri-tert-butoxysilane, ethyltriphenoxysilane, n-propyltrimethoxysilane, n-propyttriethoxysilane, n-propyltri-n- propoxysilane, n-propyltri-iso-propoxysilane, n-propyltin-n-butoxysilane, n-propyltri-sec-butoxysilane, n-propyltri-tert-butoxysilane, n-propyltriphenoxysilane, isopropyltrimethoxysilane, isopropyltriethoxysilane, isopropyltri-n-propoxysilane, isopropyltriisopropoxysilane, isopropyltri-n-butoxysilane, isopropyltri-sec-butoxysilane, isopropyltri-tert-butoxysilane, isopropyltriphenoxysilane, n-butyltrimethoxysilane, n-butyltriethoxysilane, n-butyltri-n-propoxysilane, n-butyltriisopropoxysilane, n-butyltri-n-butoxysilane, n-butyltri-sec-butoxysilane, n-butyltri-tert-butoxysilane, n-butyltriphenoxysilane; sec-butyltrimetiloxysilane, sec-butyltriethoxysilane, sec-butyltri-n-propoxysilane, sec-butyltriisopropoxysilane, sec-butyltri-n-butoxysilane, sec-butyltri-sec-butoxysilane, sec-butyltri-tert-butoxysilane, sec-butyltriphenoxysilane, tert-butyltrimethoxysilane, tert-butyltriethoxysilane, tert-butyltri-n-propoxysilane, tert-butyltriisopropoxysilane, tert-butyltri-n-butoxysilane, tert-butyltri-sec-butoxysilane, tert-butyltri-tert-butoxysilane, tert-butyltriphenoxysilane, isobutyltrimethoxysilane, isobutyltriethoxysilane, isobutyltri-n-propoxysilane, isobutyltriisopropoxysilane, isobutyltri-n-butoxysilane, isobutyltri-sec-butoxysilane, isobutyltri-tert-butoxysilane, isobutyltriphenoxysilane, n-pentyltrimethoxysilane, n-pentyltriethoxysilane, n-pentyltri-n-propoxysilane, n-pentyltriisopropoxysilane, n-pentyltri-n-butoxysilane, n-pentyltri-sec-butoxysilane, n-pentyltri-tert-butoxysilane, n-pentyltriphenoxysilane; sec-pentyltrimethoxysilane, sec-pentyltriethoxysilane, sec-pentyltri-n-propoxysilane, sec-pentyltriisopropoxysilane, sec-pentyltri-n-butoxysilane, sec-pentyltri-sec-butoxysilane, sec-pentyitri-tert-butoxysilane, sec-pentyltriphenoxysilane, tert-pentyltrimethoxysilane, tert-pentyltriethoxysilane, tert-pentyltri-n-propoxysilane, tert-pentyltriisopropoxysilane, tert-pentyltri-n-butoxysilane, tert-pentyltri-sec-butoxysilane, tert-pentyltri-tert-butoxysilane, tert-pentyltriphenaxysilane, isopentyltrimethoxysilane, isopentyltriethoxysilane, isopentyltri-n-propoxysilane, isopentyltriisopropoxysilane, isopentyltri-n-butoxysilane, isopentyltri-sec-butoxysilane, isopentyltri-tert-butoxysilane, isopentyltriphenoxysilane, neo-pentyltrimethoxysilane, neo-pentyltriethoxysilane, neo-pentyltri-n-propoxysilane, neo-pentyltriisoproxoxysilane, neo-pentyltri-n-butoxysilane, neo-pentyltri-sec-butoxysilane, neo-pentyltri-neo-butoxysiiane, neo-pentyltriphenoxysilane phenyltrimethoxysilane, phenyltriethoxysilane, phenyltri-n-propoxysilane, phenyltriisopropoxysilane, phenyltri-n-butoxysilane, phenyltri-sec-butoxysilane, phenyltri-tert-butoxysilane, phenyltriphenoxysilane, 8-trifluoropropyltrimethoxysilane, δ-trifluoropropyltriethoxysilane, dimethyldimethoxysilane, dimethyldiethoxysilane, dimethyldi-n-propoxysilane, dimethyldiisopropoxysilane, dimethyldi-n-butoxysilane, dimethyldi-sec-butoxysilane, dimethyldi-tert-butoxysilane, dimethyldiphenoxysilane, diethyldimethoxysilane, diethyldiethoxysilane, diethyldi-n-propoxysilane, diethyldiisopropoxysilane, diethyldi-n-butoxysilane, diethyldi-sec-butoxysilane, diethyldi-tert-butoxysilane, diethyldiphenoxysilane, di-n-propyldimethoxysilane, di-n-propyldimethoxysilane, di-n-propyldi-n-propoxysilane, di-n-propyldiisopropoxysilane, di-n-propyldi-n-butoxysilane, di-n-propyldi-sec-butoxysilane, din-propyldi-tert-butoxysilane, di-n-propyldiphenoxysilane, diisopropyldimethoxysilane, diisopropyldiethoxysilane, diisopropyldi-n-propoxysilane, diisopropyldiisopropoxysilane, diisopropyldi-n-butoxysilane, diisopropyldi-sec-butoxysilane, diisopropyldi-tert-butoxysilane, diisopropyldiphenoxysilane, di-n-butyldimethoxysilane, di-n-butyldiethoxysilane, di-n-butyldi-n-propoxysilane, di-n- butyldiisopropoxysilane, di-n-butyldi-n-butoxysilane, di-n-butyldi-sec-butoxysilane, di-n-butyldi-tert-butoxysilane, di-n-butyldiphenoxysilane, di-sec-butyldimethoxysilane, di-sec-butyldiethoxysilane, di-sec-butyldi-n-propoxysilane, di-sec-butyldiisopropoxysilane, di-sec-butyldi-n-butoxysilane, di-sec-butyldi-sec-butoxysilane, di-sec-butyldi-tert-butoxysilane, di-sec-butyldiphenoxysilane, di-tert-butyldimethoxysilane, di-tert-butyldiethoxysilane, di-tert-butyldi-n-propoxysilane, di-tert-butyldiisopropoxysilane, di-tert-butyldi-n-butoxysilane, di-tert-butyldi-sec-butoxysilane, di-tert-butyldi-tert-butoxysilane, di-tert-butyldiphenoxysilane, diphenyldimethoxysilane, diphenyldiethoxysilane, diphenyldi-n-propoxysilane, diphenyldiisopropoxysilane, diphenyldi-n-butoxysilane, diphenyldi-sec-butoxysilane, diphenyldi-tert-butoxysilane, diphenyldiphenoxysilane, methylneopentyldimethoxysilane, methylnenpentyldiethoxysilane, methyldimethoxysilane, ethyldimethoxysilane, n-propyldimethoxysilane, isopropyldimethoxysilane, n-butyldimethoxysilane, sec-butyldimethoxysilane, tert-butyldimethoxysilane, isobutyldimethoxysilane, n-pentyldimethoxysilane, sec-pentyldimethoxysilane, tert-pentyldimethoxysilane, isopentyldimethoxysilane, neopentyldimethoxysilane, neohexyldimethoxysilane, cyclohexyldimethoxysilane, phenyldimethoxysilane, methyldiethoxysilane, ethyldiethoxysilane, n-propyldiethxoysilane, isopropyldiethoxysilane, n-butyldiethoxysilane,

sec-butyldiethoxysilane, tert-butyldiethoxysilane, isobutyldiethoxysilane, n-pentyldiethoxysilane, sec-pentyldiethoxysilane, tert-pentyldiethoxysilane, isopentyldiethoxysilane, neopentyldiethoxysilane, neohexyldiethoxysilane, cyclohexyldiethoxysilane, phenyldiethoxysilane, trimethoxysilane, triethoxysilane, tri-n-propoxysilane, triisopropoxysilane, tri-n-butoxysilane, tri-sec-butoxysilane, tri-tert-butoxysilane, triphenoxysilane, allyltrimethoxysilane, allyltriethoxysilane, vinyltrimethoxsilane, vinyltriethoxysilane, (3-acryloxypropyl)trimethoxysilane, allyltrimethoxysilane, allyltriethoxysilane, vinyltrimethoxsilane, vinyltriethoxysilane, and (3-acryloxypropyl)trimethoxysilane. While any suitable compound(s) can be employed, specific examples of useful compounds comprise at least one of methyltrimethoxysilane, methyltriethoxysilane, methyltri-n-propoxysilane, methyltriisopropoxysilane, ethyltrimethoxysilane, ethyltriethoxysilane, dimethyldimethoxysilane, dimethyldiethoxysilane, diethyldimethoxysilane, diethyldiethoxysilane, and those with the formula $HSi(OR^1)_3$ such as trimethoxysilane, triethoxysilane, tri-n-propoxysilane, triisopropoxysilane, tri-n-butoxysilane, tri-sec-butoxysilane, tri-tert-butoxysilane, and triphenoxysilane.

The silica source may comprise a compound having the formula $Si(OR^2)_4$ wherein $R^2$ independently represents a monovalent organic group. Specific examples of the compounds represented by $Si(OR^2)_4$ comprise at least one of tetramethoxysilane, tetraethoxysilane, tetra-n-propoxysilane, tetraisopropoxysilane, tetra-n-butoxysilane, tetra-sec-butoxysilane, tetra(*tert*-butoxysilane), tetraacetoxysilane, and tetraphenoxysilane. Useful compounds may comprise at least one of tetramethoxysilane, tetraethoxysilane, tetra-n-propoxysilane, tetraisopropoxysilane, or tetraphenoxysilane.

The silica source may comprise a compound having the formula $R^3_b(R^4O)_{3-b}Si-(R^7)-Si(OR^5)_{3-c}R^6_c$, wherein $R^3$ and $R^6$ are independently a hydrogen atom, a fluorine atom, or a monovalent organic group; $R^4$ and $R^5$ are independently a monovalent organic group; b and c may be the same or different and each is a number ranging from 0 to 2; $R^7$ is an oxygen atom, a phenylene group, a biphenyl, a naphthalene group, or a group represented by $-(CH_2)_n-$, wherein n is an integer ranging from 1 to 6; or combinations thereof. Specific examples of these compounds wherein $R^7$ is an oxygen atom can comprise at least one member selected from the group of hexamethoxydisiloxane, hexaethoxydisiloxane, hexaphenoxydisiloxane, 1,1,1,3,3-pentamethoxy-3-methyldisiloxane, 1,1,1,3,3-pentaethoxy-3-methyldisilaxane, 1,1,1,3,3-pentamethoxy-3-phenyldisiloxane, 1,1,1,3,3-pentaethoxy-3-phenyldisiloxane, 1,1,3,3-tetramethoxy-9,3-dimethyldisiloxane, 1,1,3,3-tetraethoxy-1,3-dimethyldisiloxane, 1,1,3,3-tetramethoxy-1,3-diphenyldisiloxane, 1,1,3,3-tetraethoxy-1,3-diphenyldisiloxane, 1,1,3-trimethoxy-1,3,3-trimethyldisiloxane, 1,1,3-triethoxy-1,3,3-trimethyldisiloxane, 1,1,3-trimethoxy-1,3,3-triphenyldisiloxane, 1,1,3-triethoxy-1,3,3-triphenyldisilaxane, 1,3-dimethoxy-1,1,3,3-tetramethyldisiloxane, 1,3-diethoxy-1,1,3,3-tetramethyldisiloxane, 1,3-dimethoxy-1,1,3,3-tetraphenyldisiloxane and 1,3-diethoxy-1,1,3,3-tetraphenyldisiloxane. Useful compounds can comprise at least one of hexamethoxydisiloxane, hexaethoxydisiloxane, hexaphenoxydisiloxane, 1,1,3,3-tetramethoxy-1,3-dimethyldisiloxane, 1,1,3,3-tetraethoxy-1,3-dimethyldisiioxane, 1,1,3,3-tetramethoxy-1,3-diphenyldisiloxane, 1,3-dimethoxy-1,1,3,3-tetramethyldisiloxane, 1,3-diethoxy-1,1,3,3-tetramethyldisiloxane, 1,3-dimethoxy-1,1,3,3-tetraphenyldisiloxane; 1,3-diethoxy-1,1,3,3-tetraphenyldisiloxane. Specific examples of these compounds wherein $R^7$ is a group represented by $-(CH_2)_n-$ include: bis(trimethoxysilyl)methane, bis(triethoxysilyl)methane, bis(triphenoxysilyl)methane, bis(dimethoxymethylsilyl)methane, bis(diethoxymethylsilyl)methane, bis(dimethoxyphenylsilyl)methane, bis(diethoxyphenylsilyl)methane, bis(methoxydimethylsilyl)methane, bis(ethoxydimethylsilyl)methane, bis(methoxydiphenylsilyl)methane, bis(ethoxydiphenylsilyl)methane, 1,2-bis(trimethoxysilyl)ethane, 1,2-bis(triethoxysilyl)ethane, 1,2-bis(triphenoxysilyl)ethane, 1,2-bis(dimethoxymethylsilyl)ethane, 1,2-bis(diethoxymethylsilyl)ethane, 1,2-bis(dimethoxyphenylsilyl)ethane, 1,2-bis(diethoxyphenylsilyl)ethane, 1,2-bis(methoxydimethylsilyl)ethane, 1,2-bis(ethoxydimethylsilyl)ethane, 1,2-bis(methoxydiphenylsilyl)ethane, 1,2-bis (ethoxydiphenylsilyl)ethane, 1,3-bis(trimethoxysilyl)propane, 1,3-bis(triethoxysilyl)propane, 1,3-bis(triphenoxysilyl)propane, 1,3-bis(dimethoxymethylsilyl)propane, 1,3-bis(diethoxymethylsilyl)propane, 1,3-bis(dimethoxyphenylsilyl)propane, 1,3-bis(diethoxyphenylsilyl)propane, 1,3-bis(methoxydimethylsilyl)propane, 1,3-bis(ethoxydimethylsilyl)propane, 1,3-bis(methoxydiphenylsilyl)propane, and 1,3-bis(ethoxydiphenylsilyl) propane. Useful compounds can comprise bis (trimethoxysilyl)methane, bis(triethoxysilyl)methane, bis(dimethoxymethylsilyl)methane, bis(diethoxymethylsilyl)methane, bis(dimethoxyphenylsilyl) methane, bis(diethoxyphenylsilyl)methane, bis(methoxydimethylsilyl)methane, bis (ethoxydimethylsilyl)methane, bis(methoxydiphenylsilyl)methane and bis(ethoxydiphenylsilyl)methane.

In certain embodiments of the present invention, $R^1$ of the formula $RaSi(OR^1)_{4-a}$; $R^2$ of the formula $Si(OR^2)_4$; and $R^4$ and/or $R^5$ of the formula $R^3_b(R^4O)_{3+b}Si-(R^7)-Si(OR^5)_{3-c}R^6_c$ can each independently be a monovalent organic group of the formula:

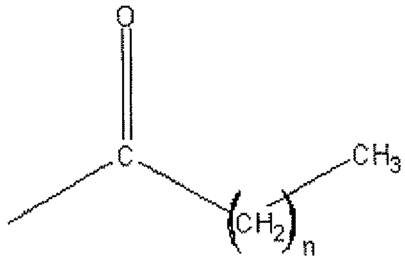

wherein n is an integer ranging from 0 to 4. Specific examples of these compounds can comprise at least one of tetraacetoxysilane, methyltriacetoxysilane, ethyltriacetoxysilane, n-propyltriacetoxysilane, isopropyltriacetoxysilane, n-butyltriacetaxysilane, sec-butyltriacetoxysilane, tert-butyltriacetoxysilane, isobutyltriacetoxysilane, n-pentyltriacetoxysilane, sec-pentyltriacetoxysilane, tert-pentyltriacetoxysilane, isopentyltriacetoxysilane, neopentyltriacetoxysilane, phenyltriacetoxysilane, dimethyldiacetoxysilane, diethyldiacetoxysilane, di-n-propyldiacetoxysilane, diisopropyldiacetoxysilane, di-n-butyldiacetoxysilane, di-sec-butyldiacetoxysilane, di-tert-butyldiacetaxysilane, diphenyldiacetoxysilane, triacetoxysilane. Useful compounds can comprise tetraacetoxysilane and methyltriacetoxysilane.

Other examples of the silica source may comprise at least one fluorinated silane or fluorinated siloxane such as those provided in U. S. Pat. No. 6,258,407; hereby incorporated by reference. Another example of the silica source may comprise compounds that produce a Si-H bond upon elimination.

In certain embodiments, the silica source comprises at least one carboxylic acid ester bonded to the Si atom. Examples of these silica sources comprise at least one of tetraacetoxysilane, methyltriacetoxysilane, ethyltriacetoxysilane, and phenyltriacetoxysilane. In addition to the at least one silica source wherein the silica source has at least one Si atom having a carboxylate group attached thereto, the composition may further comprise additional silica sources that may not necessarily have the carboxylate attached to the Si atom.

In some embodiments, a combination of hydrophilic and hydrophobic silica sources is used in the composition. The term "hydrophilic", as used herein, refers to compounds wherein the silicon atom can crosslink through four bonds. Some examples of hydrophilic sources comprise alkoxysilanes having an alkoxy functionality and can at least partially crosslink, e.g., a Si atom with four methoxy, ethoxy, propoxy, acetoxy, etc. groups, or materials with carbon or oxygen bonds between Si atoms and all other functionality on the Si atoms being an alkoxide. If the Si atoms do not fully crosslink, residual Si-OH groups may be present as terminal groups that can adsorb water. The term "hydrophobic" refers to compounds where at least one of the alkoxy functionalities has been replaced with a Si-C or Si-F bond, e.g., Si-methyl, Si-ethyl, Si-phenyl, Si-cyclohexyl, among other compounds that would not generate an Si-OH after hydrolysis. In these sources, the silicon would crosslink with less than four bridges even when fully crosslinked as a result of hydrolysis and condensation of Si-OH groups if the terminal group remains intact. When talking about the carbon (C) to silicon (Si) ratio, this ratio refers to the ratio of carbon atoms that are covalently bound to the silicon atoms rather than any carbon atoms that are part of hydrolyzable alkoxy groups attached to the silicon atom. Optionally, silica sources with a C to Si molar ratio of greater that 0.5 are used. Additionally, in some embodiments, the ratio of hydrophobic silica source to the total amount of silica source can comprise at least about 0.5 molar ratio, or ranges from about 0.5 to about 100 molar ratio, or ranges from about 0.5 to about 25 molar ratio. In certain embodiments, the hydrophobic silica source comprises a methyl group attached to the silicon atom. For the purpose of this invention, hydrophobicity is measured by conducting contact angle measurements on the cured films of the films of the invention.

The film-forming composition disclosed herein may optionally comprise at least one solvent. The term "solvent" as used herein refers to any liquid or supercritical fluid - besides water- that provides at least one of the following benefits: i) solubility with the reagents, ii) adjusts the film thickness, iii) provides sufficient optical clarity for subsequent processing steps such as, for example, lithography, iv) may be substantially removed upon curing, among other benefits. The amount of solvent that may be added to the composition ranges from about 0% to about 99% by weight, or from about 0% to about 90% by weight. Exemplary solvents useful for the film-forming composition can comprise at least one of alcohols, ketones, amides, alcohol ethers, glycols, glycol ethers, nitriles, furans, ethers, glycol esters, and/or ester solvents. The solvents could also have hydroxyl, carbonyl, or ester functionality. In certain embodiments, the solvent has one or more hydroxyl or ester functionalities such as those solvents having the following formulas: $HO\text{-}CHR^8\text{-}CHR^{9'}\text{-}CH_2CHR^{10}R^{11}$ where $R^8$, $R^9$, $R^{10}$, and $R^{11}$ can be a $CH_3$ or H; and $R^{12}\text{-}CO\text{-}R^{13}$ where $R^{12}$ is a hydrocarbon having from 3 to 6 carbon atoms; $R^{13}$ is a hydrocarbon having from 1 to 3 carbon atoms. Additional exemplary solvents comprise alcohol isomers having from 4 to 6 carbon atoms, ketone isomers having from 4 to 8 carbon atoms, linear or branched hydrocarbon acetates where the hydrocarbon has from 4 to 6 carbon atoms, ethylene or propylene glycol ethers, ethylene or propylene glycol ether acetates. Other solvents that can be used comprise at least one of 1 -propanol, 1-hexanol, 1-butanol, ethyl acetate, butyl acetate, 1-pentanal, 2-pentanol, 2-methyl-1-butanol, 2-methyl-1-pentanol, 2-ethoxyethanol, 2-methoxyethanol, 2-propoxyethanol, 1-propoxy-2-propanol, 2-heptanone, 4-heptanone, 1-tert-butoxy-2-ethoxyethane, 2-methoxyethylacetate, propylene glycol methyl ether acetate, pentyl acetate, 1-tert-butoxy-2-propanol, 2,3-dimethyl-3-pentanol, 1-methoxy-2-butanol, 4-methyl-2-pentanol, 1-tert-butoxy-2-methoxyethane, 3-methyl-1-butanol, 2-methyl-1-butanol, 2-methoxyethanol, 3-methyl-2-pentanol, 1,2-diethoxyethane, 1-methoxy-2 propanol, 1-butanol, 3-methyl-2-butanol, 5-methyl-2-hexanol, propylene glycol propyl ether, propylene glycol methyl ether, and $\gamma$-butyrolactone. Still further exemplary solvents comprise lactates, pyruvates, and diols. The solvents enumerated above may be used alone or in combination of two or more solvents. In certain embodiments wherein the film is formed by spin-on, spray-on, extrusion, or printing deposition, the film thickness of the coated substrate can be increased by lowering the amount of solvent present in the composition thereby increasing the solids content of the composition or, alternatively, by changing the conditions used to spin, level, and/or dry the film.

In alternative embodiments, the composition is substantially free of an added solvent or comprises about 0.01% by weight or less of an added solvent. In this connection, the composition described herein does not need an added solvent, for example, to solubilize the chemical reagents contained therein. The composition, however, may generate a solvent *in situ* (e.g., through hydrolysis of the reagents, decomposition of reagents, reactions within the mixture, among other interactions).

The film forming composition disclosed herein typically comprises water. In these embodiments, the amount of water added to the composition ranges from about 0.1 % to about 30% by weight, or from about 0.1% to about 25% by weight. Examples of water that can be added comprise deionized water, ultra pure water, distilled water, doubly distilled water, and high performance liquid chemical (HPLC) grade water or deionized water having a low metal content.

In certain embodiments, the composition and/or process for preparing the gate dielectric, interlayer dielectric, or planarizing film within the composition and/or during processing that meet the requirements of the electronics industry requires that the composition contains little to no contaminants, such as, for example, metals, halides, and/or other compounds that may adversely affect the electrical properties of the film. In these embodiments, the compositions described herein typically contain contaminants in amounts less than about 100 parts per million (ppm), or less than about 10 ppm, or less than about 1 ppm. In one embodiment, contaminants may be reduced by avoiding the addition of certain reagents, such as halogen-containing mineral acids, into the composition because these contaminants may contribute undesirable ions to the materials described herein. In another embodiment, contaminants may be reduced by using solvents in the composition and/or during processing that contain contaminants such metals or halides in amounts less than about 10 ppm, or less than about 1 ppm, or less than about 200 parts per billion ("ppb"). In yet another embodiment, contaminants such as metals may be reduced by adding to the composition and/or using during processing chemicals containing contaminating metals in amounts less than about 10 ppm, or less than about 1 ppm, or less than about 200 ppb. In these embodiments, if the chemical contains about 10 ppm or greater of contaminating metals, the chemical may be purified prior to addition to the composition. US Patent Application Publication No. 2004-0048960, which is incorporated herein by reference and assigned to the assignee of the present application, provides examples of suitable chemicals and methods for purifying same that can be used in the film-forming composition.

In certain embodiments, the composition may optionally comprise a porogen that is incapable of forming a micelle in the composition. The term "porogen", as used herein, comprises at least one chemical reagent that is used to generate void volume within the resultant film. Suitable porogens for use in the dielectric materials of the present invention can comprise at least one of labile organic groups, high boiling point solvents, decomposable polymers, dendrimeric polymers, hyper-branched polymers, polyoxyalkylene compounds, small molecules, and combinations thereof. The presence of porogens in the film forming solution typically leads to void generation in the film which leads to greater film flexibility and helps avoid film cracking in films that are equal to or greater than about 1 $\mu$m when applied on a substrate.

In certain embodiments of the present invention, the porogen may comprise at least one labile organic groups. When some labile organic groups are present in the reaction composition, the labile organic groups may contain sufficient oxygen to convert to gaseous products during the cure step. Some examples of compounds containing labile organic groups comprise the compounds disclosed in U. S. Pat. No. 6,171,945, which is incorporated herein by reference in its entirety.

In some embodiments of the present invention, the porogen may comprise at least one relatively high boiling point solvent. In this connection, the solvent is generally present during at least a portion of the cross-linking of the matrix material. Solvents typically used to aid in pore formation have relatively higher boiling points (e.g., about 170°C or greater or about 200°C or greater). Solvents suitable for use as a porogen within the composition of the present invention can comprise those solvents disclosed, for example, in U. S. Pat. No. 6,231,989, which is incorporated herein by reference in its entirety.

In certain embodiments, the porogen may comprise a small molecule such as those described in the reference Zheng, et al., "Synthesis of Mesoporous Silica Materials with Hydroxyacetic Acid Derivatives as Templates via a Sol-Gel Process", J. Inorg. Organomet. Polymers, 10, 103-113 (2000) which is incorporated herein by reference, or quarternary ammonium salts such as tetrabutylammonium nitrate.

The porogen could also comprise at least one decomposable polymer. The decomposable polymer may be radiation decomposable, or typically, thermally decomposable. The term "polymer", as used herein, also encompasses the terms oligomers and/or copolymers unless expressly stated to the contrary. Radiation decomposable polymers are polymers that decompose upon exposure to an ionizing radiation source, e.g., ultraviolet, X-ray, electron beam, among other sources. Thermally decomposable polymers undergo thermal decomposition at temperatures that approach the condensation temperature of the silica source materials and can be present during at least a portion of the cross-linking. Such polymers comprise those that may foster templating of the vitrification reaction, may control and define pore size, and/or may decompose and diffuse out of the matrix at the appropriate time in processing. Examples of these polymers comprise polymers that have an architecture that provides a three-dimensional structure such as those comprising block copolymers, e.g., diblock, triblock, and multiblock copolymers; star block copolymers; radial diblock copolymers; graft diblock copolymers; cografted copolymers; random copolymers, dendrigraft copolymers; tapered block copolymers; and combinations of these architectures. Further examples of decomposable polymers comprise the degradable polymers disclosed in U. S. Pat. No. 6,204,202, which is incorporated herein by reference in its entirety. Some particular examples of decomposable polymers comprise at least one of acrylates (e.g., polymethylmethacrylate methylacrylic acid copolymers (PMMA-MAA) and poly(alkylene carbonates), polyurethanes, polyethylene, polystyrene, other unsaturated carbon-based polymers and copolymers, poly(oxyalkylene), epoxy resins, and siloxane copolymers).

The porogen may comprise at least one hyper-branched or dendrimeric polymer. Hyper- branched and dendrimeric polymers generally have relatively low solution and melt viscosities, high chemical reactivity due to surface functionality, and enhanced solubility even at higher molecular weights. Some non-limiting examples of suitable decomposable hyper-branched polymers and dendrimeric polymers are disclosed in "Comprehensive Polymer Science", 2nd Supplement, Aggarwal, pp. 71-132 (1996) that is incorporated herein by reference in its entirety.

The porogen within the film-forming composition may also comprise at least one polyoxyalkylene compound such as polyoxyalkylene nonionic surfactants provided that the polyoxyalkylene nonionic surfactants are incapable of forming a micelle in the composition, polyoxyalkylene polymers, polyoxyalkylene copolymers, polyoxyalkylene oligomers, or combinations thereof. An example of such comprises a polyalkylene oxide that includes an alkylene moiety ranging from $C_2$ to $C_6$ such as polyethylene oxide, polypropylene oxide, and copolymers thereof.

In certain embodiments, the composition may optionally comprise at least one base. In these embodiments, the base is added in an amount sufficient to adjust the pH of the composition to a range of from about 0 to about 7. In certain embodiments, the base may also catalyze the hydrolysis of substitutents from the silica source in the presence of water and/or the condensation of two silica sources to form an Si-O-Si bridge. Exemplary bases can comprise at least one of quaternary ammonium salts and hydroxides, such as ammonium or tetramethylammonium hydroxide, amines such as primary, secondary, and tertiary amines, and amine oxides.

In certain embodiments, the composition may optionally comprise at least one flow and levelling agent such as those commercially available from surfactant manufacturers. Although this invention is not limited to these products and these are just representative examples, common flow and levelling agents that may be employed are Byk 307 and Byk 331 made by the Altana Group.

In another aspect there is provided a method for making a sol-gel silica-containing film for use in thin film transistors. Depending upon the film formation method, the composition may be deposited onto a substrate as a fluid. The term "fluid", as used herein, denotes a liquid phase, a gas phase, and combinations thereof (e.g., vapor) of the composition. The term "substrate", as used herein, comprises any suitable composition that is formed before the dielectric film of the present invention is applied to and/or formed on that composition. Suitable substrates that may be used in conjunction with the present invention can comprise at least one of semiconductor materials such as gallium arsenide ("GaAs"), silicon, and compositions containing silicon such as at least one of crystalline silicon, polysilicon, amorphous silicon, doped silicon, epitaxial silicon, silicon dioxide ("$SiO_2$"), silica glass, silicon nitride, fused silica, glass, quartz, borosilicate glass, and combinations thereof. Other suitable substrates can comprise at least one of chromium, molybdenum, nickel, stainless steel, and other metals commonly employed in electronic devices, electronic displays, semiconductors, flat panel displays, and flexible display applications. Other substrates include organic polymers, plastics, organic conducting materials such as pentacene, and other conducting materials that include, but are not limited to, indium tin oxide, zinc tin oxide, and other mixed oxides. The composition may be deposited onto the substrate via a variety of methods comprising at least one of dipping, rolling, brushing, spraying, extrusion, slot extrusion, spin-on deposition, printing, imprinting, stamping, other solution deposition methods, and combinations thereof.

In another aspect, there is provided a silica source capable of being sol-gel processed and comprising a compound selected from the group consisting of compounds represented by at least one of the following formulas: $R_aSi(OR^1)_{4-a}$, wherein R independently represents a hydrogen atom, a fluorine atom, or a monovalent organic group; $R^1$ represents a monovalent organic group; and a is an integer 1 or 2; $Si(OR^2)_4$, where $R^2$ represents a monovalent organic group; $R^3_b(R^4O)_{3-b}Si\text{-}R^7\text{-}Si(OR^5)_{3-c}R^6c$, wherein $R^4$ and $R^5$ may be the same or different and each represents a monovalent organic group; $R^3$ and $R^6$ may be the same or different; b and c may be the same or different and each is a number ranging from 0 to 3; $R^7$ represents an oxygen atom, a phenylene group, a biphenyl, a napthylene group, or a

group represented by $-(CH_2)_n-$, wherein n is an integer ranging from 1 to 6; and mixtures thereof; at least one solvent; at least one acid; water; and, optionally, at least one base. Optionally, the composition has a molar ratio of carbon to silicon within the silica source contained therein of at least about 0.5 or greater. Optionally, the composition may also contain a porogen, a surfactant, a flow and leveling agent, and mixtures thereof.

In another aspect, there is provided a process for preparing a film comprising a dielectric constant of about 3.5 or less on at least a portion of a substrate comprising: providing a composition comprising: at least one silica source capable of being sol-gel processed (e.g., in some cases having a molar ratio of carbon to silicon within the silica source of at least about 0.5 or greater); at least one solvent; acid; water; optionally, a base; optionally a porogen, surfactant or surface levelling agent or mixtures thereof. Normally, the composition is deposited onto a substrate to form a coated substrate and exposing the coated substrate to heat or a radiation source.

In a further aspect, there is provided a gate dielectric, interlayer dielectric, or planarization film comprising: a dielectric constant of about 3.5 or less, and the elements comprising at least one of silicon, carbon, hydrogen, and oxygen; where the film is formed from a hydrolysable silica source. This film or layer can also be formed at a relatively low temperature (e.g., by processing the inventive composition at or less than about 300°C (e.g., curing the silicate at a temperature from about 130°C to about 250°C). This film or layer can also have a leakage current density of less than about $5 \times 10^{-8}$ A/cm$^2$ (e.g., about $1 \times 10^{-8}$ A/cm$^2$ to about $1 \times 10^{-10}$ A/cm$^2$).

In another aspect, there is provided a composition for forming a gate dielectric, interlayer dielectric, or planarization material having a dielectric constant of about 3.5 or less on at least a portion of a substrate comprising: providing a composition comprising: at least one silica source capable of being sol-gel processed (e.g., with an optional molar ratio of carbon to silicon within the silica source contained therein of at least about 0.5 or greater), wherein the silica source comprises at least one compound selected from the group consisting of compounds represented by the following formulas:

a. $R_aSi(OR^1)_{4-a}$, wherein R independently represents a hydrogen atom, a fluorine atom, or a monovalent organic group; $R^1$ represents a monovalent organic group; and a is an integer of 1 or 2;

b. $Si(OR^2)_4$, where $R^2$ represents a monovalent organic group; and

c. $R^3_b(R^4O)_{3-b}Si-R^7-Si(OR^5)_{3-c}R^6_c$, wherein $R^4$ and $R^6$ may be the same or different and each represents a monovalent organic group; $R^3$ and $R^6$ may be the same or different; b and c may be the same or different and each is a number of 0 to 3; $R^7$ represents an oxygen atom, a phenylene group, a biphenyl, a napthalene group, or a group represented by $-(CH_2)_n-$, wherein n is an integer of 1 to 6; at least one solvent; acid; water; optionally, a base; optionally, a porogen, surfactant, flow leveling agent, or mixtures thereof.

The invention also encompasses the use of sol-gel silicates in cured (crosslinked) condition. Sol-gel formulations of the invention can be thermally cured by heating to a temperature of at least about 130°C, typically about 130°C to less than about 250°C, usually about 130°C to about 180°C. Optionally, crosslinking is induced in the presence of a catalyst selected from the group consisting of an acid, a base, or mixtures thereof.

One application of the silicates of the invention is thin film transistors or thin film transistor arrays. A thin film transistor comprises a substrate, a gate electrode, a gate dielectric layer, a source electrode, a drain electrode, a semiconductor layer, and an optional sealing or encapsulating layer. Figures 1-4 are embodiments of structural arrangements of these layers and electrodes in thin film transistors that may be used in this invention. These figures are merely illustrative of possible structural arrangements of the various layers and electrodes and are not intended to be limiting and are cured at temperatures at or below 250°C or, alternatively, at or below 180°C. If desired one or more layers can be located between the various layers and electrodes including those illustrated in these Figures.

Figure 1 illustrates a microelectronic device of one embodiment comprising a thin film transistor (TFT) containing the film of the instant invention. Fig 1 shows TFT 1 comprising substrate 1 over which is applied a gate electrode 2, with the gate electrode 2 in contact with substrate 1. A gate dielectric layer 3 is formed over the gate electrode 2 and substrate 1. Semiconductor layer 4 is deposited over gate dielectric layer 3. Thin film transistors also include two metal contacts, the source electrode 5 and drain electrode 6, that are deposited over the gate dielectric. The inventive film comprises layer 3 of Figure 1.

Figure 2 illustrates a TFT including a substrate 7, a gate electrode 8 in contact with substrate 7, and a gate dielectric layer 9 formed over the substrate and the gate electrode. Two metal contacts, source electrode 10 and drain electrode 11, are deposited on top of the dielectric layer 9. Over and between the metal contacts 10 and 11 is a semiconductor layer 12, The inventive film comprises layer 9 of Figure 2.

Figure 3 illustrates a TFT including substrate 13 in contact with source electrode 14 and drain electrode 15. The semiconductor layer 16 is then formed over the source electrode 14 and drain electrode 15. The gate dielectric layer 17 is then formed over the semiconductor layer 16 and the gate electrode 18 is deposited on top of the gate

dielectric layer 17. The inventive film comprises layer 17 of Figure 3.

Figure 4 illustrates a TFT including a heavily n-doped silicon wafer 19 which acts as a gate electrode, a gate dielectric layer 20 that is formed over the gate electrode 19, a semiconductor layer 21, and source electrode 22 and drain electrode 23 that are deposited on the semiconductor layer 21.

In some embodiments of the present disclosure, an optional sealing or encapsulating layer may also be included. Such an optional sealing layer may be incorporated on top of each of the transistors illustrated in Figures 1-4 or on top of the gate or interlayer dielectric film. Although this sealing layer is most commonly a silicon containing hydrophobic material such as hexamethyldisilazane, other sealing layers may also be used.

Additional details regarding the TFTs illustrated in Figures 1-4 can be found in U.S. Patent Application Publication No. 2006/0097360 A1; hereby incorporated by reference.

In addition the invention relates to any micro- or macroelectronic device comprising the silicon-containing, sol-gel compositions as defined above. In one aspect of the invention, the microelectronic device contains the silicon-containing, sol-gel compositions in cured form as a gate dielectric, interlayer dielectric or a planarization layer. Examples of such devices include but are not limited to thin film transistors, photovoltaics, solar cells, display devices, flat panel displays, flexible displays, memory devices, basic logic devices, integrated circuits, RFID tags, sensors, smart objects, or X-ray imaging devices.

Films formed from the formulation of the invention typically have a thickness of about 0.005μ to about 1.5μ. Such films can achieve a capacitance of about 5 to about 500nF/$cm^2$ and a dielectric constant of less than about 3.5.

Films from the formulaton fo the invention can also be employed as a planarizing film for planarizing a substrate (e.g., an approximately 1.1 μ planarizing film on rough stainless steel) where the substrate may include, but is not limited to, stainless steel, polymer or organic films, metals, metal oxides, silicon, silica, silicon nitride, and onther silicon-containing substrates. These formulations may be cured at temperatures from about 130°C and higher, but may also be cured at about 250°C and higher, or at or above 400°C.

In another aspect of the invention, the inventive composition can be employed for forming the dielectric film in the TFT illustrated in U.S. Patent Application Publication No. 2006/0011909; hereby incorporated by reference.

The invention will be illustrated in more detail with reference to the following Examples, but it should be understood that the present invention is not deemed to be limited thereto.

## EXAMPLES

LCDV leakage current density value measurement were obtained using the Hg probe method described below:

The mercury probe was made by MSI electronics model Hg-401. The contact area of the mercury probe is 0.7 $mm^2$ with +/- 2% of uncertainty. The power source and current meter is a Keithley 6517A. The mercury probe is placed in a Faraday cage to reduce the electric noise. The connection between the controller and mercury probe are BNC cables. The noise level of the system is less than 100 fA.

Thin films were coated on a low resistant wafer (0.01 ohm) before the measurement. The thicknesses of the films were about 200nm to 500nm. The sample was placed face down on the mercury probe so mercury will contact on the surface of the film and the other metal disk will contact the backside of the wafer. The measurements were done by applied a constant voltage on the sample and measure the current through the film. The reported LCDV is the current that was measured 3 minutes after applied a voltage to a film to avoid the charging current between the wafer and the insulated plate of the mercury probe.

### Example 1: Fabrication and Characterization of Gate Dielectric or Interlayer Dielectric for Thin Film Transistors

A dielectric film was prepared by combining 0.94 grams of methyltrimethoxysilane, 0.96 grams of triethoxysilane, and 0.13 grams of 3,3,3-trifluoropropyltrimethoxysilane and adding 2.50 grams of PGPE. This solution was shaken for three minutes. In a separate solution, 1.2 grams of 0.01 M HNO3, and 0.02g 0.1% by weight aqueous tetramethylammonium hydroxide solution were combined then added to the silane and solvent mixture. The solution was shaken for one minute and was homogeneous. The resulting solution was allowed to age for 6 days (ambient conditions) and 1mL of it was filtered by through a 0.2 μ filter before depositing it on a silicon wafer by spin coating at 500 rpm for 7 seconds then 1800 rpm for 40 seconds. The silicate-containing wafer was at 250°C for 3 min. on a hot plate. The capacitance of the resulting 0.6μ layer was measured as 5nF/$cm^2$ via a mercury probe and had a dielectric constant of 3.22. The refractive index of this film was 1.386. The leakage current density value for this film on a silicon wafer was 8.6 x $10^{-9}$ A/cm2.

### Example 2: Thin Film Transistor Fabrication

Thin film transistors are fabricated using silicate precursor solutions of Example 1 via spin-coating and printing techniques.

Example 3: Planarization of Stainless Steel Foils

1.61 g of methyltriethoxysilane, 1.61g of tetraethoxysilane, 2.50g of propylene glycol propyl ether, and 1.00g of Triton X-114 were combined in a 30g vial. To this mixture was added 1.71g of 0.1M $HNO_3$, followed by 0.07g of 2.4wt% TMAH, and the vial was shaken for 2 minutes. After aging the solution for 1 day, 2mL of solution was applied via spin coating at a spin speed of 7 seconds at 500rpm and 40 seconds at 1800rpm onto a 6" square stainless steel foil to give approximately a 1.4μ planarization film on the foil. The uncoated foil had an average rms roughness of 101 nm over a 25μ × 25μ square area. The stainless steel foil containing the sol-gel silicate was then cured by heating the substrate to 90°C for 90 seconds, to 180°C for 90 seconds, and to 400°C for 3 minutes on a hot plate. The now-planarized substrate rms roughness was an average of 13.25nm rms roughness over a 25μ x 25μ square area.

Example 4: Post Treatment of Films with hydrophobic Layer Improves Leakage Current (LC)

Dielectric films were prepared by combining 2.25 grams of methyltriethoxysilane, 2.25 grams of tetraethoxysilane and adding 5.8 grams of PGPE. In a separate solution, 2.4 grams of 0.1 M HNO3, and 0.2g 0.26N aqueous tetramethylammonium hydroxide solution were combined then added to the silane and solvent mixture. The solution was shaken for one minute and was homogeneous. The resulting solution was allowed to age for 6 days (ambient conditions) and 1 mL of it was filtered by through a 0.2 μ filter before depositing it on a silicon wafer by spin coating at 500 rpm for 7 seconds then 1800 rpm for 40 seconds. Three silicate-containing wafer were spun. Film 4a was baked at 250°C for 3 min. on a hot plate. Film 4b was baked at 150°C for 5 min. on a hot plate. Film 4b was then treated with hexamethyldisilazane (HMDS) by placing 3 ml of filtered HMDS onto the film and spinning at 500 rpm for 40 sec then 1800 for 40 sec. Film 4b was then baked at 150°C for 5 min. on a hot plate. Film 4c was baked at 250°C for 3 min. on a hot plate. Film 4c was then treated with hexamethyldisilazane (HMDS) by placing 3 ml of filtered HMDS onto the film and spinning at 500 rpm for 40 sec then 1800 for 40 sec. Film 4c was then baked at 250°C for 3 min. on a hot plate. The leakage current density value (LCDV) for this film 4a on a silicon wafer was $1.9 \times 10^{-9}$ A/cm$^2$ when measured in $N_2$ and the LCDV was $8\text{-}10 \times 10^{-7}$ A/cm$^2$ when measured in air at constant temperature and humidity (CTH) set at 71°F and 42% humidity. The leakage LCDV for this film 4b on a silicon wafer was $3.1 \times 10^{-6}$ A/cm$^2$ when measured in $N_2$. The LCDV for this film 4c on a silicon wafer was 1.53 x $10^{-9}$ A/cm$^2$ when measured in $N_2$ and the LCDV was $4\text{-}10 \times 10^{-9}$ A/cm$^2$ when measured in air at CTH.

Comparative Example 1 (Hydrophillic Film)

2.25 g Tetraethylorthosilicate (TEOS) was weighed in a 1 oz. poly bottle. 2.50g Propylene glycol propyl ether (PGPE) or 1-propoxy-2-propanol was added. The mixture was briefly shaken. 1.25g of a solution containing 96% 0.1M Nitric acid and 4% 0.26M aqueous Tetramethylammonium hydroxide solution was added. The mixture was shaken for about a minute. The solution was ambient aged overnight then spun onto a 4 inch prime P type 1-0-0 low resistivity Si wafer, 1 min. @ 1500 RPM, solution charge-about 1 ml, filtered when applied, 0.2 um syringe filter. The resulting wafer with film was calcined on hotplates at 90°C for 1.5 min, 180°C for 1.5 min. then 400°C for 3 min. The film was analyzed on a Sentech SE800 ellipsometer: thickness-496.89 nm, porosity-4.5%, refractive index-1.44. The film was then analyzed on a mercury probe. Average leakage current density was $4.5\times1\ 0^{-4}$ A/cm$^2$ at 1.5 MV/cm when measured in $N_2$. Two other positions on the wafer broke down upon applying a voltage.

Example 5 Post Treatment of Films with Hydrophobic Layer and Contact Angle Measurements

The following formulations were made as listed in the table below: Compostion 5a 5b 5c TEOS 2.25 4.275 2.25 MTES 2.25 0.225 1.8 TFTS 0 0 0.45 PGPE 6.2 6.2 6.8 0.1 M HNO3 2.4 2.4 2.4 0.26N TMAH 0.2 0.2 0.2 TFTS = 1,1,1 tridecafluoro 1,1,2,2 tetrahydroxyl triethoxysilane TMAH = Tetramethylammonium hydroxide

Each formulation was prepared in a manner similar to that described in Example 1. The resulting solutions were filtered through a 0.2 μ filter (1mL) before depositing them on a silicon wafer by spin coating at 500 rpm for 7 seconds then 1800 rpm for 40 seconds. Two films were spun from 5a and 5b. The silicate-containing wafers were baked at 250°C for 3 min. on a hot plate. A film from both 5a and 5 b were placed on spinner and 2.5 ml of hexamethyldisilazane ((HMDS) was deposited onto each wafer. The spinner was ramped to 500 rpm for 30 sec then increased to 1500 rpm for 35 sec. These two films were each baked again at 250°C for 3 min. on a hot plate. The contact angle of water on each film was measured 5a =92°, 5b = 22°, 5c = 120°, 5a plus HMDS =120, 5b with HMDS =57°. In this case, high contact angle values for water on these films correlates with the film being more hydrophobic.

| | Sample 5a | Sample 5a and HMDS | Sample 5b | Sample 5b and HMDS | Sample 5c |
|---|---|---|---|---|---|
| Contact Angle | 92° | 120° | 22° | 57° | 120° |

Although certain aspects of the invention are illustrated and described herein with reference to given embodiments, it is not intended that the appended claims be limited to the details shown. Rather, it is expected that various modifications may be made in these details by those skilled in the art, which modifications may still be within the spirit and scope of the claimed subject matter and it is intended that these claims be construed accordingly.

## Claims

**1.** A gate dielectric or interlayer dielectric layer of a thin film transistor wherein the layer comprises a sol-gel silica-containing formulation that has been processed at a temperature of less than about 250°C.

**2.** The gate dielectric layer of Claim 1 wherein said layer comprises a silica containing sol-gel composition wherein the composition comprises: i) at least one silica source, ii) at least one compound selected from the group consisting of compounds represented by at least one of the following formulas:

$R_aSi(OR^1)_{4-a}$, wherein R independently represents a hydrogen atom, a fluorine atom, or a monovalent organic group; $R^1$ represents a monovalent organic group; and a is an integer 1 or 2; $Si(OR^2)_4$, where $R^2$ represents a monovalent organic group; and,
$R^3_b(R^4O)_{3-b}Si\text{-}R^7\text{-}Si(OR^5)_{3-c}R^6_c$, wherein $R^4$ and $R^5$ may be the same or different and each represents a monovalent organic group; $R^3$ and $R^6$ may be the same or different; b and c may be the same or different and each is a number ranging from 0 to 3; $R^7$ represents an oxygen atom, a phenylene group, a biphenyl, a napthylene group, or a group represented by $-(CH_2)_n-$ , wherein n is an integer ranging from 1 to 6;

iii) at least one solvent;
iv) water;
v) at least one acid;
vii) optionally, at least one base; and,
viii) optionally, a surfactant, a porogen, a flow and leveling agent, or mixtures thereof.

**3.** The gate or interlayer dielectric of claim 2 that contains a silica source with a C to Si molar ratio of 0.5 or greater.

**4.** A planarizing film for substrates wherein the film comprises a sol-gel silica-containing formulation that forms a planarizing film of greater than about 1μ by one coating step.

**5.** The planarizing film of claim 4 that is used for thin film transistor substrates and the film comprises the composition of Claim 2.

**6.** The planarizing film of claim 5 wherein the film has an rms roughness value of about < 20nm on a substrate of greater than 90nm rms roughness.

**7.** The planarizing film of claim 5 that planarizes stainless steel.

**8.** The planarizing film of claim 5 that planarizes plastics.

**9.** The planarizing film of claim 5 that is cured at 400°C.

**10.** A thin film transistor comprising:

a gate electrode;
a gate dielectric layer comprising a silica containing sol-gel composition of Claim 2;
a source electrode;
a drain electrode; and,
a semiconductor layer.

**11.** The thin film transistor of claim 10 wherein the silica source for the gate or interlayer dielectric contains a C to Si molar ratio of 0.5 or greater.

**12.** A thin film transistor comprising:

a gate electrode;
a gate dielectric layer comprising the sol-gel composition of claim 1
a source electrode;
a drain electrode;
a semiconductor layer;

wherein the dielectric layer has a dielectric constant of less than about 3.5.

**13.** The thin film transistor of claim 12 , wherein the dielectric layer has a capacitance of greater than about 5nF/cm2.

**14.** The thin film transistor of claim 12 , wherein the dielectric layer has a leakage current density of less than about 5 x 10-8 A/cm2.

**15.** The thin film transistor of claim 12 , wherein the silica-containing sol-gel composition is present as a cured film, said cured film being cured between about 135°C and about 250°C, having a dielectric constant below about 3.5, and having a capacitance of greater than about 5nF/$cm^2$.

**16.** A process for preparing a planarizing film comprising a dielectric constant of less than about 3.5 on at least a portion of a substrate, the process comprising: providing a composition comprising: at least one silica source capable of being sol-gel processed and containing sol-gel composition wherein the materials suitable as the silica source include silica sources capable of being sol-gel processed and comprising a compound selected from the group consisting of compounds represented by at least one of the following formulas:

$R_aSi(OR^1)_{4-a}$, wherein R independently represents a hydrogen atom, a fluorine atom, or a monovalent organic group; $R^1$ represents a monovalent organic group; and a is an integer 1 or 2; $Si(OR^2)_4$, where $R^2$ represents a monovalent organic group;
$R^3_b(R^4O)_{3-b}Si-R^7Si(OR^5)_{3-c}R^6_c$, wherein $R^4$ and $R^5$ may be the same or different and each represents a monovalent organic group; $R^3$ and $R^6$ may be the same or different; b and c may be the same or different and each is a number ranging from 0 to 3; $R^7$ represents an oxygen atom, a phenylene group, a biphenyl, a napthylene group, or a group represented by $-(CH_2)_n-$, wherein n is an integer ranging from 1 to 6;

at least one solvent; water; at least one acid; optionally, at least one base; optionally, a surfactant, a porogen, a flow and levelling agent, or mixtures thereof;
wherein the film is cured between 130°C and 250C° in air.

**17.** An electronic device containing the planarizing film of claim 4.

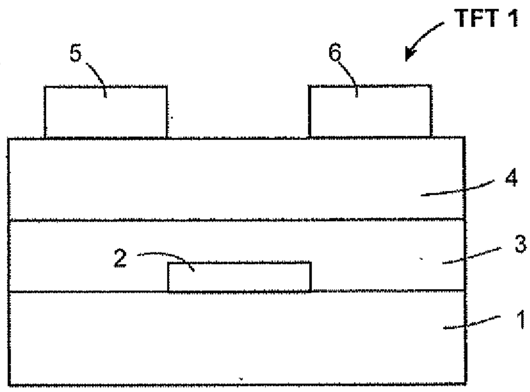


Figure 1

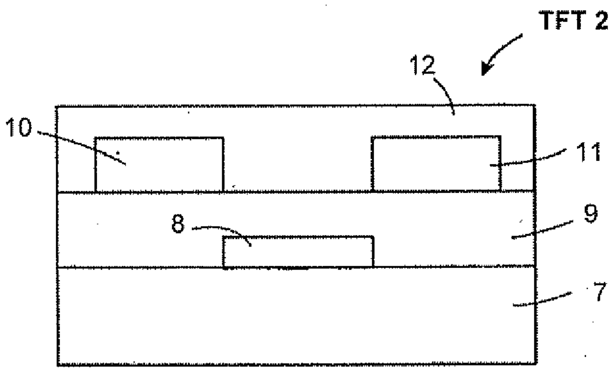


Figure 2

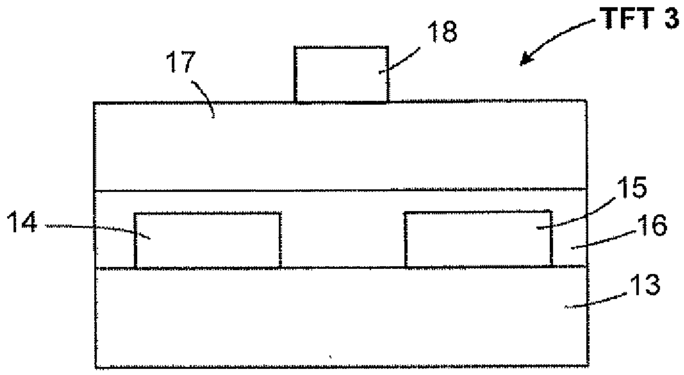


Figure 3

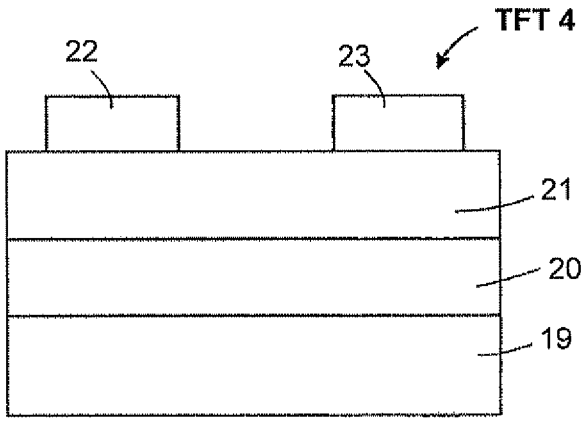


Figure 4

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

### Patent documents cited in the description


- US 83116106 P
- US 20060097360 A1
- US 752722 A
- US 6258407 B
- US 20040048960 A
- US 6171945 B
- US 6231989 B
- US 6204202 B
- US 20060011909 A


### Non-patent literature cited in the description


- **ZHENG et al.** Synthesis of Mesoporous Silica Materials with Hydroxyacetic Acid Derivatives as Templates via a Sol-Gel Process. *J. Inorg. Organomet. Polymers,* 2000, vol. 10, 103-113
- *Comprehensive Polymer Science,* 1996, 71-132